(19) **Europäisches Patentamt**

**European Patent Office**

**Office européen des brevets**

(11) **EP 1 418 671 A2**

(12) **EUROPÄISCHE PATENTANMELDUNG**

(43) Veröffentlichungstag:
   **12.05.2004 Patentblatt 2004/20**

(51) Int Cl.⁷: **H03H 9/17**

(21) Anmeldenummer: **03025372.8**

(22) Anmeldetag: **04.11.2003**

(84) Benannte Vertragsstaaten:
   **AT BE BG CH CY CZ DE DK EE ES FI FR GB GR HU IE IT LI LU MC NL PT RO SE SI SK TR**
   Benannte Erstreckungsstaaten:
   **AL LT LV MK**

(30) Priorität: **07.11.2002 DE 10251876**

(71) Anmelder: **Infineon Technologies AG**
   **81669 München (DE)**

(72) Erfinder:
   • **Marksteiner, Stephan Dr.**
     **85640 Putzbrunn (DE)**

   • **Fattinger, Gernot**
     **81737 München (DE)**
   • **Aigner, Rober**
     **81675 München (DE)**
   • **Kaitila, Jyrki**
     **00530 Helsinki (FI)**

(74) Vertreter: **Zimmermann, Tankred Klaus et al**
   **Schoppe, Zimmermann, Stöckeler & Zinkler**
   **Patentanwälte**
   **Postfach 246**
   **82043 Pullach bei München (DE)**

(54) **Akustischer Reflektor für einen BAW-Resonator**

(57)    Ein BAW-Resonator, umfasst eine piezoelektrische Schicht (102) mit einer ersten Oberfläche und einer zweiten, der ersten Oberfläche gegenüberliegenden Oberfläche, eine erste Elektrode (104), die an der ersten Oberfläche der piezoelektrischen Schicht (102) angeordnet ist, eine zweite Elektrode (106), die an der zweiten Oberfläche der piezoelektrischen Schicht (102) angeordnet ist, ein Substrat (108), und einen akustischen Reflektor (110), der zwischen dem Substrat (108) und der zweiten Elektrode (106) angeordnet ist, wobei der akustische Reflektor (110) eine Mehrzahl von Schichten aus einem Material mit hoher akustischer Impedanz und aus einem Material mit niedriger akustischer Impedanz aufweist, wobei alternierend Bereiche mit Schichten mit hoher akustischer Impedanz und Bereiche mit Schichten mit niedriger akustischer Impedanz benachbart angeordnet sind. Ein Verhalten des akustischen Reflektors (110) ist durch dessen Reflexionsvermögen für eine in dem BAW-Resonator (100) existierende longitudinale Welle (210) bei der Resonanzfrequenz des BAW-Resonators (100) und durch dessen Reflexionsvermögen für eine in dem BAW-Resonator (100) existierende Scherwelle (212) bei der Resonanzfrequenz des BAW-Resonators (100) bestimmt ist. Die Schichten des akustischen Reflektors (110) und zwischen dem akustischen Reflektor (110) und der piezoelektrischen Schicht (102) angeordnete Schichten (106a,106b) sind in Bezug auf deren Anzahl, Material und Dicke derart ausgewählt sind, dass die Transmissivität für die longitudinale Welle und die Transmissivität für die Scherwelle im Bereich der Resonanzfrequenz kleiner als -10dB ist.

FIG 2A

EP 1 418 671 A2

**Beschreibung**

Die vorliegende Erfindung bezieht sich auf einen akustischen Reflektor (akustischer Spiegel) für einen BAW-Resonator (BAW = Bulk Acoustic Wave = akustische Volumenwelle), und hier insbesondere auf einen akustischen Reflektor mit einer Mehrzahl von Schichten für ein verbessertes Verhalten des BAW-Resonators.

Die vorliegende Erfindung betrifft vorzugsweise BAW-Filter für HF-Anwendungen, und hier insbesondere BAW-Filter für HF-Anwendungen, bei denen eine ausgezeichnete Selektivität und steile Übergangsbänder erforderlich sind. Bei solchen Filtern sind die kritischsten Parameter der Qualitätsfaktor (Güte) und der Kopplungskoeffizient der BAW-Resonatoren. Der Kopplungskoeffizient ist durch die Frequenzen definiert, bei denen eine serielle Resonanz und eine parallele Resonanz auftritt. Der Kopplungskoeffizient ist eine Funktion der e-lektro-mechanischen Kopplung der piezoelektrischen Schicht des BAW-Resonators sowie der Dicke und der verwendeten Materialtypen in der Gesamtanordnung des BAW-Resonators, welcher eine Mehrzahl von Schichten aufweist, um einen Schichtenstapel zu bilden. Hinsichtlich der oben erwähnten seriellen Resonanz und parallelen Resonanz wird darauf hingewiesen, dass hierunter das elektrische Resonanzverhalten eines BAW-Resonators zu verstehen ist, d.h. die serielle Resonanz entspricht dem Impedanzminimum und die parallele Resonanz dem Impedanzmaximum der frequenzabhängigen Impedanzkennlinie des Resonators.

Die Güte ist durch den relativen Energieverlust in dem BAW-Resonator definiert. Der Energieverlust basiert entweder aufgrund des Austretens akustischer Signale, was auch als akustische Leckage bezeichnet wird, aufgrund elektrischer Effekte oder durch viskose Verluste (Dämpfung) der akustischen Wellen in dem Schichtenstapel.

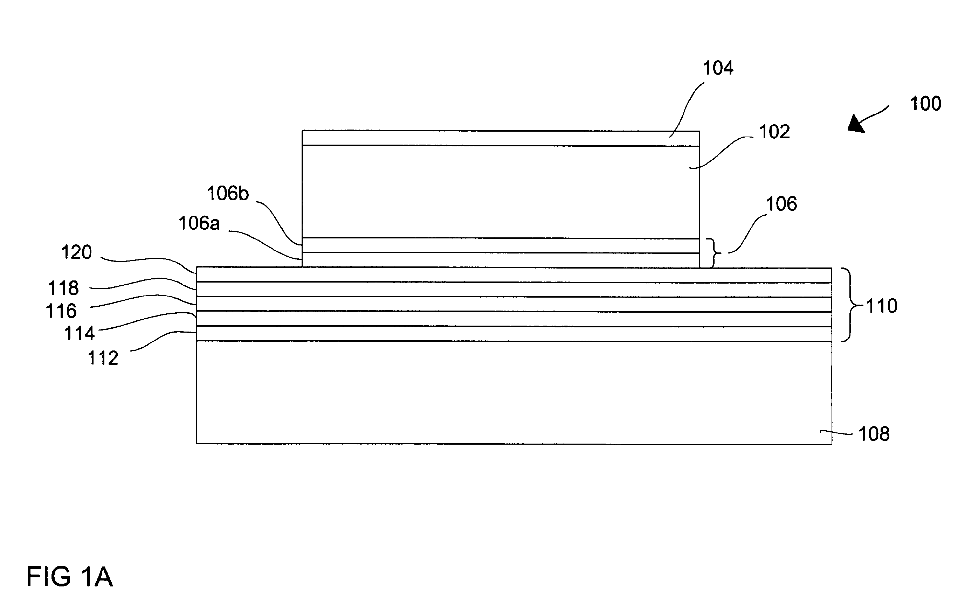

Fig. 1A zeigt eine schematische Darstellung eines herkömmlichen BAW-Resonators, der bei dem gezeigten Ausführungsbeispiel eine Resonanzfrequenz von etwa 1840 MHz aufweist. Der BAW-Resonator 100 umfasst eine piezoelektrische Schicht 102, beispielsweise aus Aluminiumnitrid (AlN). Ferner umfasst der BAW-Resonator 100 eine obere Elektrode 104, die ihrerseits aus mehreren metallischen und dielektrischen Schichten aufgebaut sein kann. Eine untere Elektrode 106 des BAW-Resonators 100 kann ebenfalls aus mehreren metallischen und dielektrischen Schichten aufgebaut sein.

Bei dem gezeigten Beispiel umfasst die untere Elektrode 106 eine erste Schicht 106a aus einem Material mit einer niedrigen Impedanz, z. B. Aluminium (A1), und eine zweite Schicht 106b aus einem Material mit einer hohen akustischen Impedanz, z. B. Wolfram (W). ).

Bei dem dargestellten Beispiel hat die piezoelektrische Schicht 102 eine Dicke von 1200 nm. Wie erwähnt, kann die obere Elektrode 104 eine Mehrzahl von Schichten umfassen, wobei hier eine Al-Schicht der oberen Elektrode 104 eine Dicke von etwa 200 nm aufweist, und eine W-Schicht der oberen Elektrode 104 hat eine Dicke von etwa 150 nm. Die W-Schicht 106a der unteren Elektrode 106 hat eine Dicke von etwa 150 nm, und die Al-Schicht 106b der unteren Elektroden 106 hat eine Dicke von etwa 200 nm.

Der BAW-Resonator gemäß Fig. 1A umfasst ferner ein Substrat 108, beispielsweise ein Siliziumsubstrat. Auf einer dem Resonatorelement 100 zugewandten Oberfläche des Substrats 108 ist ein akustischer Spiegel oder akustischer Reflektor 110 gebildet, der zwischen dem Substrat 108 und der unteren Elektrode 106 angeordnet ist. Der akustische Spiegel 110 umfasst eine Mehrzahl von Schichten 112, 114, 116, 118, 120, die aus einem Material mit hoher akustischer Impedanz und einem Material mit niedriger akustischer Impedanz hergestellt sind, wobei abwechselnd Schichten aus einem Material mit hoher akustischer Impedanz und Schichten aus einem Material mit niedriger akustischer Impedanz angeordnet sind. Der Spiegel 110 ist für die oben genannte Resonanzfrequenz von etwa 1840 MHz des Resonators entworfen. Es handelt sich hier um einen $\lambda/4$-Spiegel, wie er herkömmlicherweise verwendet wird.

Die erste Schicht 112 besteht aus einem Material mit einer niedrigen akustischen Impedanz, z. B. $SiO_2$, die zweite Schicht 114 besteht aus einem Material mit hoher akustischer Impedanz, z.B. W, die dritte Schicht 116 besteht aus einem Material mit einer niedrigen akustischen Impedanz, z. B. $SiO_2$, die vierte Schicht 118 besteht aus einem Material mit hoher akustischer Impedanz, z.B. W, und die fünfte Schicht 120 besteht aus einem Material mit einer niedrigen akustischen Impedanz, z. B. $SiO_2$. Bei dem dargestellten Beispiel sind die Schichten 112, 116 und 120 $SiO_2$-Schichten gleicher Dicke, z.B. 810 nm bei der betrachteten Resonanzfrequenz, und die Schichten 114 und 118 sind W-Schichten gleicher Dicke, z.B. 710 nm bei der betrachteten Resonanzfrequenz.

Der typische Q-Faktor (Güte), wie er für einen BAW-Resonator auf einem akustischen Spiegel, wie er beispielhaft in Fig. 1A gezeigt ist, erhalten werden kann, liegt im Bereich von etwa 400 bis 700. Diese Werte sind zwar ausreichend, um mit SAW-Bauelementen (SAW = Surface Acoustic Wave = akustische Oberflächenwelle) für Anwendungen im Mobilfunkbereich mitzuhalten, jedoch sind diese Werte nicht annähernd ausreichend, um beispielsweise Antennenduplexer oder andere anspruchsvolle Filter mit niedrigem Verlust und hoher Selektivität, z. B. US-CDMA-Filter oder W-CDMA-Filter, herzustellen. Heutzutage sind auf dem Markt erhältliche Duplexer große Keramikkomponenten, da die SAW-Filter keine ausreichende Leistungshandhabungsfähigkeit aufweisen. CDMA-Filter werden oft durch sogenannte "Split-Band"-SAW-Filter hergestellt, die zwei parallel geschaltete Filter mit unterschiedlichen Mittenfrequenzen verwenden, da ein einzelnes SAW-Filter keine ausreichend steilen Übergangscharakteristika aufweisen würde.

Es sei hier erwähnt, dass eine Verbesserung der Güte für BAW-Resonatoren auf Werte größer als 700 nicht nur für CDMA-Filter von großem Interesse sind. Generell führt eine Verbesserung der Güte der Resonatoren zu einer Performance-Verbesserung der Filter (z.B. Filterbandbreitenerhöhung und/oder Verbesserung des Stehwellenverhältnisses) und damit zu einer besseren Ausbeute bei der Massenfertigung dieser Bauelemente.

Für die oben erwähnten Verlustmechanismen existiert keine auf breiter Basis akzeptierte Theorie hinsichtlich desjenigen Mechanismus, der in BAW-Resonatoren dominant ist. viskose Verluste (Dämpfungen durch das Material) und elektrische Verluste durch den ohmschen Widerstand der Elektroden und der Verdrahtung wurden bisher als Hauptverdächtige angesehen. Elektrische Verluste wurden gut charakterisiert, und es kann gezeigt werden, dass diese nicht die dominierenden Verluste sind. Auch für viskose Verluste ist es unwahrscheinlich, dass diese den begrenzenden oder beschränkenden Faktor darstellen, da sekundäre akustische Moden in den Resonatoren sehr oft sehr hohe Q-Faktoren aufweisen, welche nicht vorhanden wären, wenn die Materialien selbst eine starke Dämpfung der akustischen Wellen hervorrufen würden. So wurden beispielsweise von K.M. Lakin, u.a. IEEE Trans. Microwave Theory, Vol. 41, No. 12, 1993 experimentelle Ergebnisse von Overmode-Resonatoren mit Güten von 68000 gezeigt.

Interferometrische Messungen haben ergeben, dass ein Teil der Energie auch durch laterale akustische Wellen verloren wird, was bedeutet, dass die Energieeinschließung nicht perfekt arbeitet. Um diesen Verlustmechanismus zu vermeiden, wurde ein experimenteller Resonator mit einem "Luft"-Graben (ungefüllter Graben) aufgebaut, der den aktiven Bereich umgab, so dass keine Wellen in der lateralen Richtung entkommen konnten. Diese experimentelle Anordnung führte zu dem überraschenden Ergebnis, dass sich der Q-Faktor gegenüber herkömmlichen Resonatorelementen nur marginal änderte, was ein Hinweis darauf ist, dass der Energieverlust durch laterale akustische Wellen ebenfalls nicht dominierend ist.

Es konnte bereits experimentell gezeigt werden, dass eine rauhe Substrat-Rückseite (Wafer-Rückseite) einen signifikanten Einfluss auf die sekundären Moden in BAW-Resonatoren hat, die akustische Spiegel aufweisen. Dies ist als Anzeichen zu sehen, dass vertikale Wellen als mögliche Quelle von Verlusten in Betracht zu ziehen sind. Um dies zu verifizieren, wurden Proben vorbereitet, welche polierte Rückseiten aufweisen. Es wurde herausgefunden, dass starke Reflexionen der Wellen von der Rückseite nach dem Polieren auftraten, die bei den Proben mit der rauhen Rückseite nicht vorhanden waren. Dies bedeutet, dass bei den Proben mit den polierten Rückseiten die akustische Wellenenergie, die zuvor an der rauhen Rückseitenoberfläche gestreut und folglich verloren wurde, nun zurück reflektiert und in die piezoelektrische Schicht zurückgekoppelt wird. Ferner konnten die Erfinder nachweisen, unter Verwendung der Laserinterferometrie, dass an der Rückseite Vibrationen auftreten. Nachdem die akustischen Spiegel für die longitudinalen Wellen in dem Resonatorelement bei dessen Betriebsfrequenz optimiert sind, ist dies ein starker Hinweis darauf, dass die an den Rückseiten beobachteten Wellen Scherwellen sind.

An dieser Stelle ist festzuhalten, dass alle relevanten Veröffentlichungen betreffend akustische Spiegel für BAW-Resonatoren lediglich das Reflexionsvermögen des Spiegels für longitudinale Wellen, also für sich in Richtung der elastischen Auslenkung ausbreitende Wellen beschreiben, da dies der einzig offensichtliche Wellentyp ist, der durch herkömmliche, stark ausgerichtete piezoelektrische Dünnfilmschichten erzeugt wird. Ferner handelt es sich bei diesem Wellentyp um denjenigen, der die Hauptresonanz eines BAW-Elements durch eine stehende Wellenbedingung in dem Stapel definiert. Akustische Spiegel sind Bragg-Reflektoren, die verschiedene Schichten mit hoher und niedriger akustischer Impedanz aufweisen. Herkömmlicherweise werden Schichtdicken verwendet, die so nah als möglich an eine Abmessung im Bereich von $\lambda/4$ ($\lambda$ = Wellenlänge) der longitudinalen Wellen liegen, da hier eine optimale Reflektivität/optimales Reflexionsvermögen bei der Hauptresonanzfrequenz erreicht wird.

Scherwellen werden in idealen unendlich großen Resonatoren nicht angeregt, da dort keine piezoelektrische Kopplung zwischen einem vertikalen elektrischen Feld und den Scher-Spannungen in einer Piezoschicht mit einer dominanten C-Achsen Kristallausrichtung existiert. Im Stand der Technik ist keine Veröffentlichung bekannt, die den Effekt von Scherwellen in Dünnschicht-BAW-Resonatoren erläutert oder beschreibt. Es existieren drei Gründe, warum Scherwellen in realen Resonatoren dennoch erzeugt werden:

(a) In der piezoelektrischen Schicht des BAW-Resonators können geneigte Korngrenzen auftreten. Wenn diese Neigung auch nur zu einem geringen Anteil eine bevorzugte Richtung aufweist, dann kann ein vertikales Feld zu einer Einkopplung von Scherwellen in der piezoelektrischen Schicht führen.

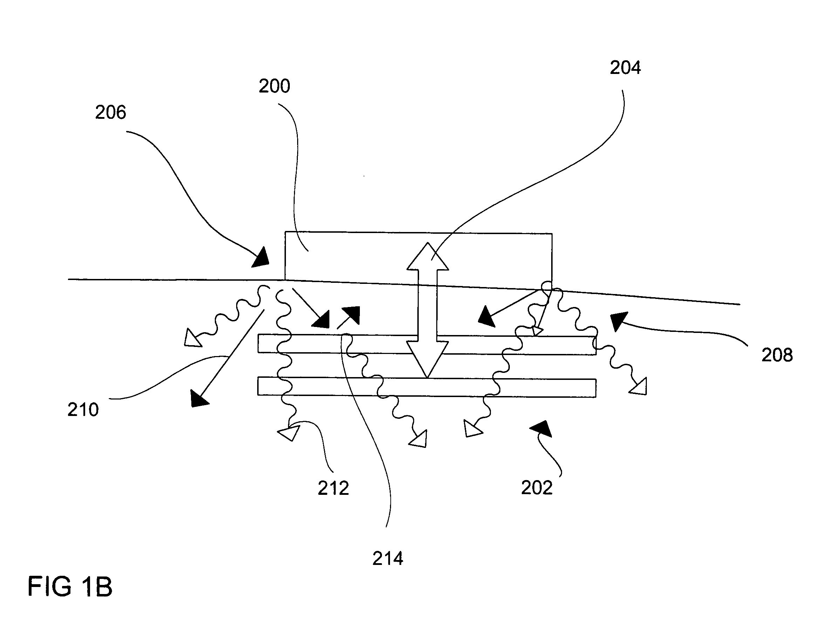

(b) An den Kanten eines Resonators müssen bestimmte akustischen Randbedingungen für die Grenzfläche zwischen dem aktiven Bereich und dem außerhalb liegenden Bereich erfüllt sein. Wenn diese Grenzbedingungen zwischen dem außerhalb liegenden Bereich und dem aktiven Bereich nicht gut aufeinander angepasst sind, kann eine Erzeugung von Scherwellen an dem Umfang des Resonators auftreten. Physikalisch gesehen, führt die laterale Berandung des Resonators zur Erzeugung von akustischen Streuwellen, die sich in alle Raumrichtungen (natürlich nur innerhalb des Festkörpers) und mit allen möglichen Polarisationen ausbreiten, was in Fig. 1B schematisch dargestellt ist. In Fig. 1B ist bei 200 schematisch der Resonator gezeigt, der die in Fig. 1A gezeigten Elektroden 104 und 106 sowie die piezoelektrische Schicht 102 umfasst. Der Spiegel ist schematisch bei 202 gezeigt. Der Pfeil 204 verdeutlicht die longitudinale Anregung im gesamten aktiven Bereich des Bauelements. Die Pfeile 206 und 208 zeigen am Rand des Resonators 200 entstehende Streuwellen, wobei die Streuwellen sowohl longitudinale Anteile 210 (gerade Pfeile) als auch Scherwellen-Anteile 212 (gewellte Pfeile) umfassen.

(c) Die longitudinalen Wellen 210, die sich in eine Richtung bewegen, die nicht exakt senkrecht zu der Substrateebene ist (siehe Fig. 1B), werden zumindest teilweise in Scherwellen 212 an den Schnittstellen 214 der unterschiedlichen Schichten umgewandelt. Diese Scherwellen 212 können dann leicht den akustischen Spiegel 202 passieren, da dieser nur für eine Reflexion der longitudinalen Wellen optimiert ist.

Nachdem die meisten Filmmaterialien für akustische Resonatoren Poisson-Verhältnisse im Bereich von etwa 0,17 bis 0,35 haben, bewegt sich die Geschwindigkeit der Scherwellen im Regelfall bei etwa der Hälfte der Geschwindigkeit der longitudinalen Wellen. Aus diesem Grund kann es bei λ/4-Spiegeln, die zur Reflexion longitudinaler Wellen entworfen wurden, leicht dazu kommen, dass die Scherwellen nicht oder nicht ausreichend gut reflektiert werden. Tatsächlich liegt die akustische Schichtdicke der Schichten des Spiegels für Scherwellen bei etwa λ/2, was genau der Anti-Reflexions-Bedingung für diesen Typ von Wellen (also einer möglichst hohen Transmission) entspricht.

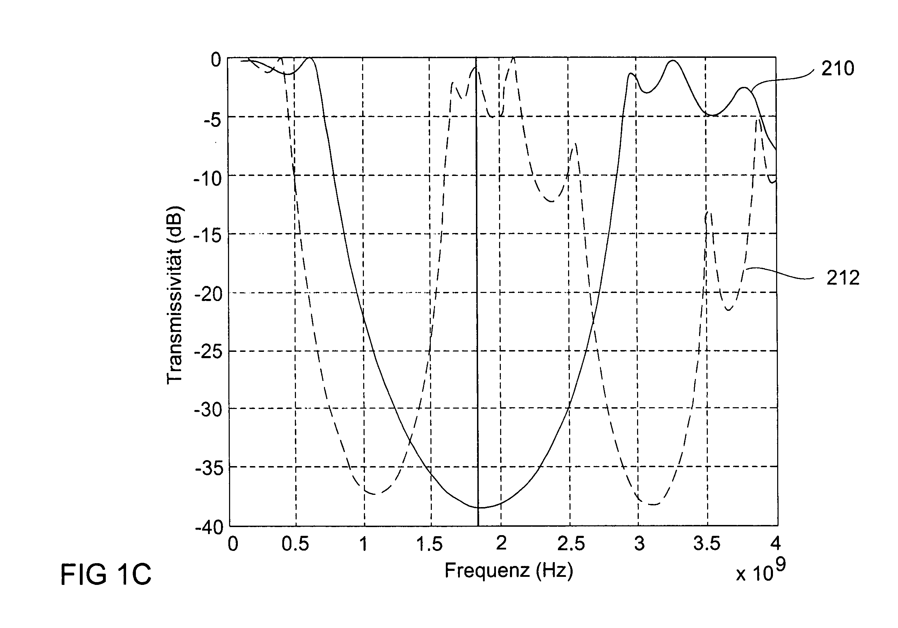

Diese Situation ist für das in Fig. 1A gezeigte Beispiel eines BAW-Resonators mit den dort angegebenen Abmessungen in Fig. 1C näher erläutert. Über einen Frequenzbereich von 1 GHz bis 4 GHz ist dort die Durchlässigkeit des akustischen Spiegels 110 für in dem BAW-Resonator existierende longitudinale Wellen 210 und Scherwellen 212 dargestellt. An dieser Stelle sei darauf hingewiesen, dass alle Schichten unterhalb der piezoelektrischen Schicht 102 (siehe Fig. 1A), also bei dem in Fig. 1A gezeigten Beispiel die Schichten 106a, 106a, 112, 114, 116, 118 und 120, in ihrer Wirkung als akustischer Reflektor zu berücksichtigen sind, also insbesondere auch die Schichten 106a und 106b der unteren Elektrode 106. Der Grund hierfür ist, dass auch die Elektroden eine reflektierende Wirkung auf die in der piezoelektrischen Schicht erzeugten akustischen Wellen haben. Die Eigenschaft "Reflektivität" kann nur der Gesamtheit aller unterhalb der piezoelektrischen Schicht 102 liegenden Schichten sinnvoll zugeordnet werden, so dass unter dem Begriff "akustischer Reflektor" oder "akustischer Spiegel" bei der Betrachtung der Reflexionseigenschaft desselben die Gesamtheit der zwischen der piezoelektrischen Schicht 102 und dem Substrat 108 angeordneten Schichten zu verstehen ist.

Um die Reflektivität eines akustischen Spiegels mit n Schichten (in Fig. 1A gilt n = 5 Bragg-Schichten + 2 Elektrodenschichten = 7) zu berechnen, kann die Transformationsgleichung eines Abschlusswiderstandes durch eine lange Leitung (siehe Gleichung (1) unten) verwendet werden, die aus dem sogenannten Mason-Modell erhalten wird (siehe W.P. Mason, Physical Acoustics I, Part A, Academic Press, NY, 1994), um eine Gesamteingangsimpedanz $Z_i$ zu erhalten (siehe K.M. Lakin, u.a. IEEE Trans. Microwave Theory, Vol. 41, No. 12, 1993). Es gilt:

$$Z_i = z_i \left[ \frac{Z_{i-1} \cdot \cos\theta_i + i \cdot z_i \cdot \sin\theta_i}{z_i \cdot \cos\theta_i + i \cdot Z_{i-1} \cdot \sin\theta_i} \right] \qquad (1)$$

mit:

i = 1...n, wobei "1" die an das Substrat angrenzende Schicht und "n" die an die Piezoschicht angrenzende Schicht nummeriert

$z_i$ = die akustische Impedanz der betrachteten Schicht i,

$Z_{i-1}$ = die gesamte akustische Impedanz der bisher betrachteten Schichten 1 bis i-1, und

$\theta_i$ = die Gesamtphase über die Schicht i.

$\theta_i$ wird gemäß folgender Berechnungsvorschrift bestimmt:

$$\theta_i = \frac{\omega \cdot d_i}{v_i} \qquad (2)$$

mit:

$v_i$ = die Geschwindigkeit der akustischen Welle in der Schicht i, abhängig vom Polarisationszustand.

$d_i$ = die Dicke der Schicht i, und

$\omega$ = Winkelfrequenz.

Für einen gegebenen Stapel, siehe z.B. Fig. 1A, wird mit der Berechnung des gesamten Eingangsimpedanz bis zu der ersten Schicht 112 benachbart zum Substrat 108 unter Verwendung der obigen Gleichungen begonnen, wobei für die erste Berechnung $Z_{i-1} = Z_{sub}$ = Substratimpedanz und $z_i = z_1$ = akustische Impedanz der Schicht 1 (Schicht 112 in Fig. 1A) gilt. Für die nächste Schicht, die Schicht 2 (Schicht 114 in Fig. 1A), werden ebenfalls die obigen Gleichungen herangezogen, wobei dann $Z_{i-1} = Z_1$ = berechnete Gesamtimpedanz bis zu der Schicht 1 und die anderen Parameter wie für Schicht 2 gelten. Diese Berechnung wird für alle Schichten bis zu der piezoelektrischen Schicht wiederholt.

Der Spiegelreflexionskoeffizient berechnet sich dann gemäß der folgenden Berechnungsvorschrift:

$$R = \frac{Z_n - z_p}{Z_n + z_p} \tag{3}$$

mit:

$Z_n$ = berechnete Impedanz aller Spiegel- und Elektrodenschichten, und
$z_p$ = die akustische Impedanz der piezoelektrischen Schicht.

Im Allgemeinen ist der Reflexionskoeffizient ein komplexer Wert, dessen Betrag die Amplitude der reflektierten Welle beschreibt (bezogen auf die Amplitude der einfallenden Welle), und dessen Phase den effektiven Phasensprung der reflektierten Welle wiederspiegelt.

Die obige Berechnung kann sowohl für longitudinale Welle als auch für Scherwellen unter Verwendung der in der nachstehenden Tabelle beispielhaft für unterschiedliche Materialien angegebenen Werte für akustische Impedanzen und Wellengeschwindigkeiten für die unterschiedlichen Wellen berechnet werden.

| Material | $v_1$ für eine longitudinale Welle | $z_1$ für eine longitudinale Welle ($10^6$ kg/m$^2$s) | $v_s$ für eine Scherwelle | $z_s$ für eine Scherwelle ($10^6$ kg/m$^2$s) |
|---|---|---|---|---|
| Al | 6422 m/s | 17,3 | 3110 m/s | 8,4 |
| W | 5230 m/s | 101 | 2860 m/s | 55,2 |
| AlN | 10400 m/s | 34 | 6036 m/s | 19,7 |
| SiO$_2$ | 5970 m/s | 13,1 | 3760 m/s | 8,3 |
| Si | 8847 m/s | 19,3 | 5300 m/s | 11,6 |
| SiN | 11150 m/s | 36.2 | 6160 | 20 |

Basierend auf den obigen Werten kann die Reflektivität des Spiegels sowohl für longitudinale Wellen als auch für Scherwellen berechnet werden. Soll das Ergebnis als Transmissivität in dB ausgedrückt werden, so wird dieselbe wie folgt berechnet:

$$T_{dB} = 10 \cdot \log\left(1 - |R|^2\right).$$

Wie aus Fig. 1C zu erkennen ist, ist der Verlauf der Durchlässigkeit des Spiegels für longitudinale Wellen 210 im Bereich der Betriebsfrequenz von etwa 1,8 GHz sehr niedrig (bei etwa -38dB), d. h. longitudinale Wellen werden im Frequenzbereich von etwa 1,0 bis 2,7 GHz sehr stark reflektiert, der Spiegel hat also eine hohe Reflektivität. Betrachtet man sich die im Vergleich dazu aufgetragene Durchlässigkeit des Spiegels für die Scherwellen 212, so erkennt man ohne weiteres, dass hier die Transmissivität im Bereich der Betriebsfrequenz (1,8 GHz) für die Scherwellen sehr hoch ist (etwa -2dB), also ein großer Anteil der durch die Scherwellen transportierten Energie nicht reflektiert wird, sondern aus dem BAW-Resonator austritt und verloren geht.

Ausgehend von diesem Stand der Technik liegt der vorliegenden Erfindung die Aufgabe zugrunde, einen BAW-Resonator mit einem akustischen Reflektor zu schaffen, dessen Verhalten bei der Resonanzfrequenz verbessert ist.

Diese Aufgabe wird durch einen BAW-Resonator nach Anspruch 1 gelöst.

**EP 1 418 671 A2**

Die vorliegende Erfindung schafft einen BAW-Resonator, mit einer piezoelektrischen Schicht mit einer ersten Oberfläche und einer zweiten, der ersten Oberfläche gegenüberliegenden Oberfläche, einer ersten Elektrode, die an der ersten Oberfläche der piezoelektrischen Schicht angeordnet ist, einer zweiten Elektrode, die an der zweiten Oberfläche der piezoelektrischen Schicht angeordnet ist, einem Substrat, und einem akustischen Reflektor, der zwischen dem Substrat und der zweiten Elektrode angeordnet ist, wobei der akustische Reflektor eine Mehrzahl von Schichten aus einem Material mit hoher akustischer Impedanz und aus einem Material mit niedriger akustischer Impedanz aufweist, wobei alternierend Bereiche mit Schichten mit hoher akustischer Impedanz und Bereiche mit Schichten mit niedriger akustischer Impedanz benachbart angeordnet sind,
wobei ein Verhalten des akustischen Reflektors durch dessen Reflexionsvermögen für eine in dem BAW-Resonator existierende longitudinale Welle bei der Resonanzfrequenz des BAW-Resonators und durch dessen Reflexionsvermögen für eine in dem BAW-Resonator existierende Scherwelle bei der Resonanzfrequenz des BAW-Resonators bestimmt ist, und
wobei die Schichten des akustischen Reflektors und zwischen dem akustischen Reflektors und der piezoelektrischen Schicht angeordnete Schichten in Bezug auf deren Anzahl, Material und Dicke derart ausgewählt sind, dass die Transmissivität für die longitudinale Welle und die Transmissivität für die Scherwelle im Bereich der Resonanzfrequenz kleiner als -10dB ist.

Vorzugsweise ist die Transmissivität für die longitudinale Welle und die Transmissivität für die Scherwelle im Bereich der Resonanzfrequenz kleiner als -15dB. Gemäß einem weiteren bevorzugten Ausführungsbeispiel ist die Transmissivität für die longitudinale Welle im Bereich der Resonanzfrequenz kleiner als -20dB, und die Transmissivität für die Scherwelle im Bereich der Resonanzfrequenz ist kleiner als -15dB.

Vorzugsweise sind die Schichten mit niedriger akustischer Impedanz aus $SiO_2$ oder Al hergestellt, und die Schichten mit hoher akustischer Impedanz sind aus Wolfram hergestellt.

Gemäß einem weiteren Aspekt schafft die vorliegende Erfindung einen BAW-Resonator, bei dem die Schichten des akustischen Resonators gewählt sind, so dass der BAW-Resonator ein eindeutiges und erwünschtes Dispersionsverhalten aufweist. Vorzugsweise sind die Schichten gewählt, so dass der Abstand zwischen der longitudinalen Hauptresonanz und der ersten Scher-Oberwelle größer als die Bandbreite des Resonators, vorzugsweise größer als die Bandbreite der longitudinalen Hauptresonanz des Resonators, ist.

Gemäß einem weiteren Aspekt schafft die vorliegende Erfindung eine Filterschaltung mit einer Mehrzahl von BAW-Resonatoren, welche die erfindungsgemäßen akustischen Reflektoren verwenden, wobei vorzugsweise die Resonatorelemente und die akustischen Reflektoren der BAW-Resonatoren auf einem gemeinsamen Substrat gebildet sind.

Nachfolgend werden anhand der beiliegenden Zeichnungen bevorzugte Ausführungsbeispiele der vorliegenden Erfindung näher erläutert. Es zeigen:

Fig. 1A   eine schematische Darstellung eines BAW-Resonators mit einer Resonanzfrequenz von etwa 1,8 GHz mit einem herkömmlichen akustischen Reflektor;

Fig. 1B   eine schematische Darstellung zur Entstehung von akustischen Streuwellen an der lateralen Berandung eines BAW-Resonators;

Fig. 1C   den Verlauf der Durchlässigkeit des herkömmlichen akustischen Reflektors aus Fig. 1A zwischen 0,1 GHz und 4 GHz für eine in dem BAW-Resonator existierende longitudinale Welle und eine in dem BAW-Resonator existierende Scherwelle;

Fig. 2A   eine schematische Darstellung eines BAW-Resonators mit einer Resonanz-Frequenz von etwa 1,8 GHz und einem akustischen Reflektor gemäß einem ersten und einem zweiten Ausführungsbeispiel der vorliegenden Erfindung;

Fig. 2B   den Verlauf der Durchlässigkeit des akustischen Reflektors gemäß dem ersten Ausführungsbeispiel zwischen 0,1 GHz und 4 GHz für eine in dem BAW-Resonator existierende longitudinale Welle und für eine in dem BAW-Resonator existierende Scherwelle;

Fig. 2C   den Impedanzverlauf laut Mason-Modell für einen BAW-Resonator mit dem akustischen Reflektor gemäß dem ersten Ausführungsbeispiel zwischen 0,7 GHz und 2,1 GHz bei Verwendung von longitudinalen Materialparametern und Scherwellenmaterialparametern;

Fig. 2D   den Verlauf der Durchlässigkeit des akustischen Reflektors gemäß dem zweiten Ausführungsbeispiel zwischen 0,1 GHz und 4 GHz für eine in dem BAW-Resonator existierende longitudinale Welle und für eine in dem BAW-Resonator existierende Scherwelle;

Fig. 2E    den Impedanzverlauf laut Mason-Modell für einen BAW-Resonator mit dem akustischen Reflektor gemäß dem zweiten Ausführungsbeispiel zwischen 0,7 GHz und 2,1 GHz bei Verwendung von longitudinalen Materialparametern (210) und Scherwellenmaterialparametern (212);

Fig. 3    eine schematische Darstellung eines Filters mit einer Mehrzahl von erfindungsgemäßen BAW-Resonatoren.

In der nachfolgenden Beschreibung der bevorzugten Ausführungsbeispiele werden ähnliche Elemente in den einzelnen Zeichnungen mit ähnlichen oder gleichen Bezugszeichen versehen.

Die vorliegende Erfindung schafft akustische Spiegel bzw. akustische Reflektoren für BAW-Resonatoren, welche zu einer signifikanten Verbesserung der Güte (Q-Faktor) führen. BAW-Resonatoren, welche die erfindungsgemäßen akustischen Reflektoren aufweisen, sind insbesondere für Anwendungen notwendig, welche Q-Faktoren größer als 700 erfordern, wie beispielsweise der oben erwähnte Einsatz bei Antennenduplexern und anderen Filteranwendungen, welche niedrige Verluste und hohe Selektivität erfordern, z. B. die erwähnten US-CDMA-Filter oder W-CDMA-Filter.

Erfindungsgemäß wird ein verbesserter akustischer Reflektor/akustischer Spiegel geschaffen, welcher den Austritt von akustischer Energie (akustische Leckage) in die vertikale Richtung, also in Richtung in der die einzelnen Schichten des Elements übereinander angeordnet sind, vermieden wird.

Erfindungsgemäß wird gemäß einem ersten bevorzugten Ausführungsbeispiel der vorliegenden Erfindung die Reflektivität, also das Reflexionsvermögen des akustischen Spiegels sowohl für die longitudinale Welle als auch für die Scherwelle optimiert.

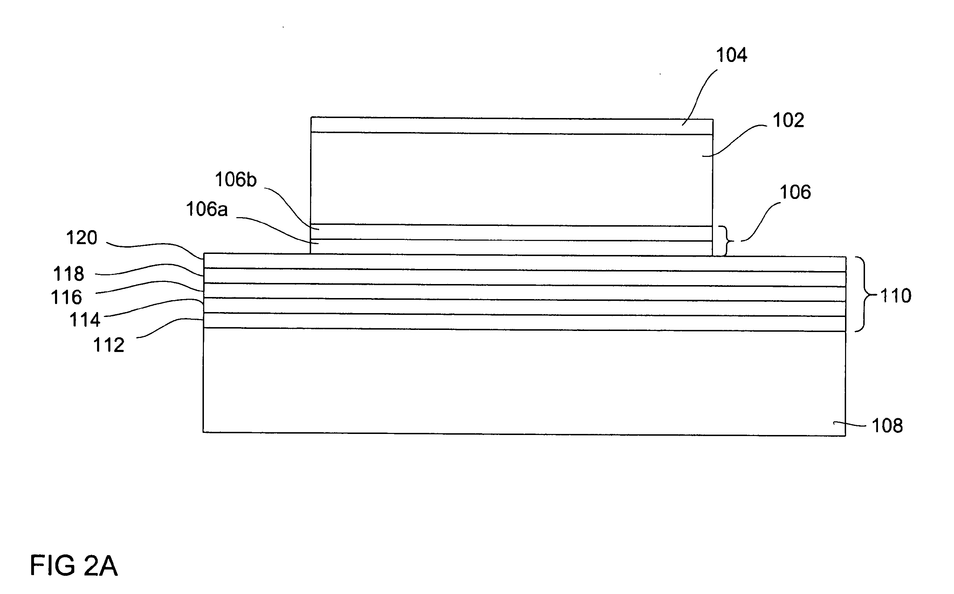

In Fig. 2A ist ein erstes Ausführungsbeispiel eines BAW-Resonators gezeigt, welcher einen akustischen Spiegel gemäß der vorliegenden Erfindung aufweist. Vom Aufbau her ist das in Fig. 2A gezeigte Element hinsichtlich der Abfolge der Schichten ähnlich zu dem in Fig. 1A gezeigten Element, jedoch wurden hier erfindungsgemäß andere Schichtdicken für die einzelnen Schichten des akustischen Spiegels gewählt. Der BAW-Resonator in Fig. 2A hat, wie jener in Fig. 1, eine Resonanzfrequenz von etwa 1840 MHz. Bei dem gezeigten Beispiel umfasst die untere Elektrode 106 auch hier eine erste Schicht 106a aus einem Material mit einer niedrigen Impedanz, nämlich Aluminium (A1), und eine zweite Schicht 106b aus einem Material mit einer hohen akustischen Impedanz, nämlich Wolfram (W). Die piezoelektrische Schicht 102 hat eine Dicke von 1200 nm. Die obere Elektrode 104 kann eine Mehrzahl von Schichten umfassen, wobei hier eine Al-Schicht der oberen Elektrode 104 eine Dicke von etwa 200 nm aufweist, und eine W-Schicht der oberen Elektrode 104 hat eine Dicke von etwa 150 nm. Die W-Schicht 106a der unteren Elektrode 106 hat eine Dicke von etwa 150 nm, und die Al-Schicht 106b der unteren Elektroden 106 hat eine Dicke von etwa 200 nm.

Die erste Schicht 112 des akustischen Reflektors 110 ist eine Schicht mit einer niedrigen akustischen Impedanz, z. B. $SiO_2$ mit einer Dicke von etwa 600 nm. Die zweite Schicht 114 ist eine Schicht aus einem Material mit hoher akustischer Impedanz, nämlich Wolfram, und einer Dicke von etwa 500 nm. Die dritte Schicht 116 ist eine Schicht mit niedriger akustischer Impedanz, nämlich $SiO_2$, welche eine Dicke von etwa 600 nm hat. Die vierte Schicht 118 ist eine Schicht aus einem Material mit hoher akustischer Impedanz, nämlich Wolfram welches eine Schichtdicke von etwa 500 nm hat. Die fünfte Schicht 120 ist eine Schicht aus einem Material mit niedriger akustischer Impedanz, nämlich $SiO_2$ welches eine Schichtdicke von etwa 850 nm hat.

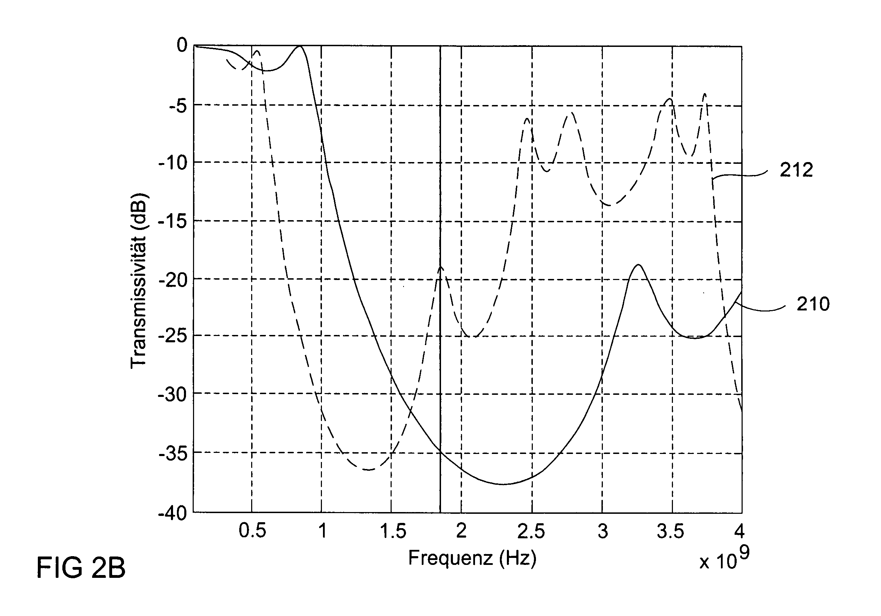

Das anhand der Fig. 2A beschriebene Ausführungsbeispiel umfasst einen akustischen Reflektor, der einen Kompromiss hinsichtlich des Reflexionsvermögens des Spiegels für eine longitudinale Welle sowie für eine Scherwelle darstellt. In Fig. 2B ist die Spiegeldurchlässigkeit über den Frequenzbereich von 0,1 GHz bis 4 GHz für die longitudinale Welle 210 und für die Scherwelle 212 aufgetragen. Im Bereich der Betriebsfrequenz von 1,8 GHz ist die Durchlässigkeit des Spiegels für die Scherwelle 212 bei etwa -18dB, und die Durchlässigkeit des Spiegels für die longitudinale Welle 210 ist bei etwa - 35dB, so dass sowohl die Scherwelle als auch die longitudinale Welle eine sehr hohe Reflexion bei der Betriebsfrequenz durch den akustischen Spiegel erfahren.

Verglichen mit Fig. 1B kann ohne weiteres erkannt werden, dass durch eine geringfügige Erhöhung der Durchlässigkeit um etwa 3 dB für die longitudinale Welle eine sehr starke Absenkung der Durchlässigkeit des Spiegels für die Scherwelle erreicht wurde, so dass im Bereich der Resonanzfrequenz 1,8 GHz durch den erfindungsgemäßen akustischen Reflektor sichergestellt ist, dass auch die von der Scherwelle transportierte Energie zurückreflektiert wird und nicht aus dem Spiegel austritt und verloren geht. Hierdurch kann eine deutliche Verbesserung des Q-Faktors erreicht werden, so dass dieser über 700 liegt, so dass solche BAW-Resonatoren ohne weiteres auch in Anwendungen verwendet werden können, welche so hohe Q-Faktoren benötigen, wie beispielsweise die oben erwähnten Duplexer oder Filteranordnungen mit niedrigen Verlusten und hoher Selektivität.

Bisher wurde zur Optimierung des Resonatorverhaltens vorgeschlagen, die Spiegelgüte für longitudinale Wellen und Scherwellen zu optimieren. Es gibt jedoch noch eine weitere Eigenschaft des Schichtstapels des BAW-Resonators, welche sehr stark von den Schichtdicken der Spiegelschichten beeinflusst wird und welche ihrerseits einen starken Einfluss auf das Resonatorverhalten (Resonator-Performance) hat, nämlich den sog. "Dispersionstyp". Der "Dispersionstyp wird eingehend in der WO 01/06647 A diskutiert).

Die exakte Berechnung des Dispersionstyps benötigt in der Regel eine 2-dimensionale akustische Theorie von Vielschichtsystemen (siehe z.B. M.J.S. Lowe, IEEE Trans. UFFC, Vol.42, No.4, 1995), es lässt sich jedoch auch mit dem oben erwähnten eindimensionalen Mason-Modell ein guter Überblick über das Dispersionsverhalten erzielen. Dazu berechnet man in einem ersten Schritt das elektrische Impedanzverhalten des Schichtstapels in der einem Fachmann bekannten Weise (d.h. unter Verwendung der longitudinalen akustischen Materialeigenschaften). In einem zweiten Schritt wiederholt man die Berechnung, allerdings verwendet man nun die Scherwellenmaterialparameter (siehe die oben angegebene Tabelle). Die dabei berechneten Impedanzkennlinie hat zwar keine elektrische Relevanz, weil eine solche stehende Scherwelle nicht durch ein vertikales elektrisches Feld in einer c-Achsen-orientierten Piezoschicht angeregt werden kann. Allerdings zeigen die Resonanzen in der Kennlinie sehr wohl die Frequenzen, bei denen mechanische Resonanzen mit stehenden Scherwellen auftreten können. Der Dispersionstyp ergibt sich dann aus dem Abstand zwischen der longitudinalen Hauptresonanz und der ersten Scher-Oberwelle. Ist die ersten Scher-Oberwelle unterhalb der longitudinalen Hauptresonanz so spricht man im Sinne der WO 01/06647 A von einer Typ-I-Dispersion, im ungekehrten Fall von einer Typ-II-Dispersion.

Beide Typen von Dispersion erlauben die Optimierung des Resonatorverhaltens in Bezug auf spuriöse Moden (spurious modes), wobei jedoch beide Arten eine deutlich unterschiedliche Form der Randgestaltung benötigen (siehe WO 01/06647 A). Es ist somit leicht verständlich, dass in dem Fall in dem nun die ersten Scher-Oberwelle und die longitudinalen Hauptresonanz sehr nahe beieinander liegen (d.h. der Abstand ist kleiner als die Bandbreite der longitudinalen Resonanz), der eine Dispersionstyp in den anderen übergeht, und somit der Dispersionstyp nicht eindeutig bestimmt ist. Dieser Fall ist ungünstig, weil dann nicht klar ist, welche Art von Randgestaltung zur Unterdrückung von spuriöse Moden zu verwenden ist.

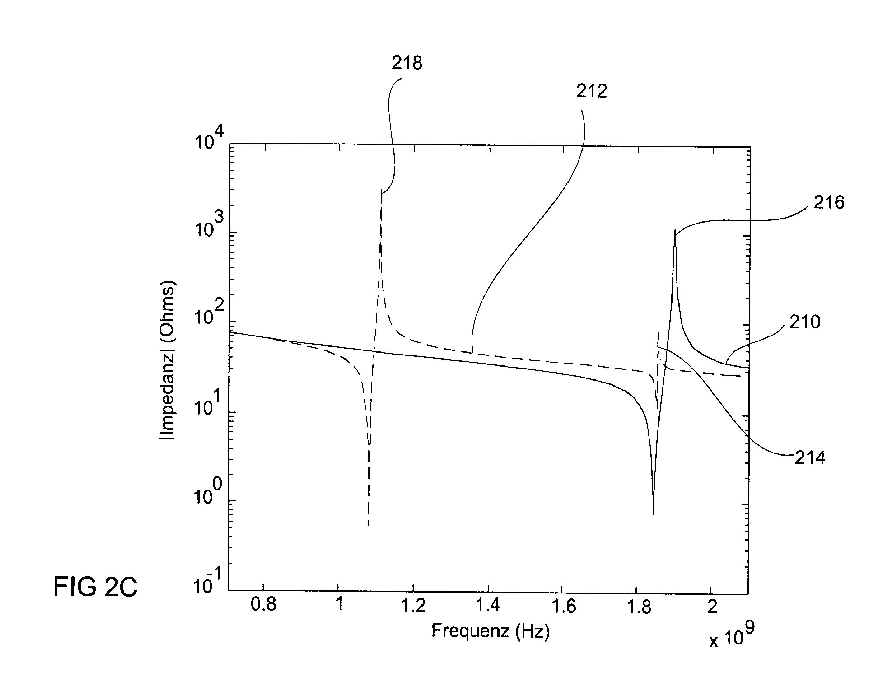

In Fig. 2C ist das Ergebnis der oben erwähnten Berechnung mit dem Mason-Modell für das erste erfindungsgemäße Ausführungsbeispiel (Fig. 2A) dargestellt. Fig. 2C zeigt den Impedanzverlauf laut dem Mason-Modell für einen BAW-Resonator mit dem akustischen Reflektor gemäß dem ersten Ausführungsbeispiel (siehe Fig. 2A) zwischen 0,7 GHz und 2,1 GHz. Das Bezugszeichen 210 bezeichnet, analog zu Fig. 2B, den Impedanzverlauf für longitudinale Materialparameter, und das Bezugszeichen 212 bezeichnet, analog zu Fig. 2B, den Impedanzverlauf für Scherwellenmaterialparameter. In Fig. 2C bezeichnet das Bezugszeichen 214 die erste Scher-Oberwelle, das Bezugszeichen 216 bezeichnet die longitudinale Hauptresonanz, und das Bezugszeichen 218 bezeichnet die Scher-Hauptresonanz. Es zeigt sich, dass in diesem Fall genau der oben beschriebene ungünstige Fall auftritt. Zur Vermeidung dieser Situation sollte bei der Optimierung des Spiegelverhaltens im Sinne dieser Patentschrift die Randbedingung eingehalten werden, dass der Frequenzabstand von erster Scher-Oberwelle und longitudinaler Hauptresonanz größer als die Bandbreite der longitudinalen Hauptresonanz ist. Dies schränkt die Menge der geeigneten Spiegelschichtfolgen deutliche eine und erschwert die Optimierung, allerdings sind moderne Optimierungsprogramme problemlos in der Lage solche Nebenbedingungen zu berücksichtigen.

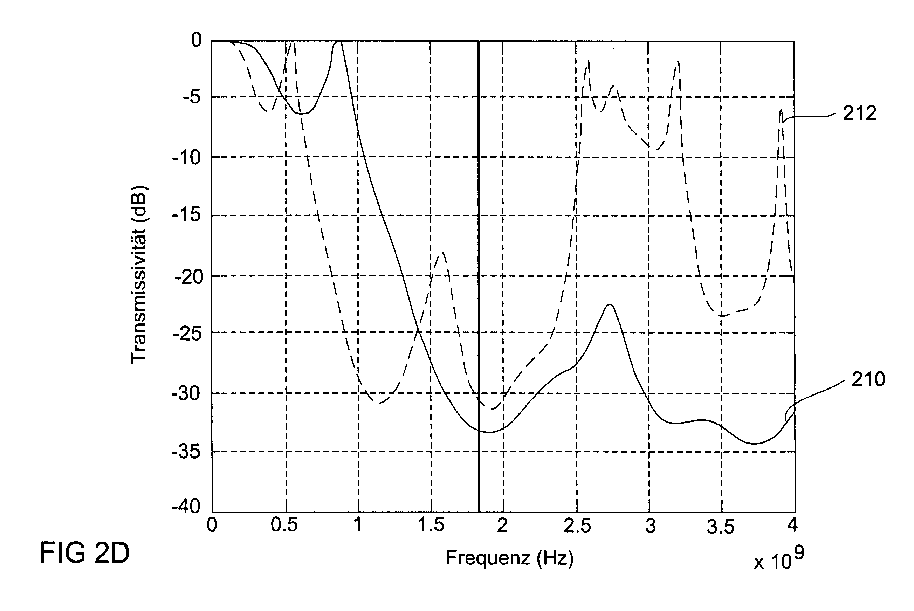

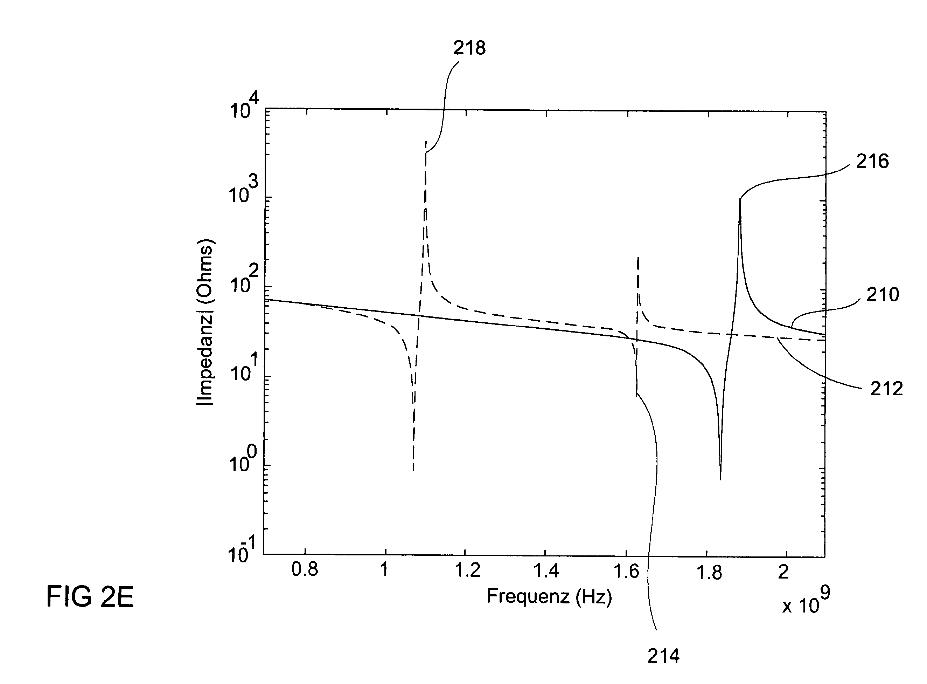

Ein Bespiel für eine solche Optimierung mit Nebenbedingung ist in Fig. 2D und 2E dargestellt. Die Schichtfolge ist wiederum identisch zum ersten Ausführungsbeispiel, allerdings sind die Dicken der einzelnen Schichten wie folgt gewählt: Die unterste Schicht 112 ist $SiO_2$ mit 2600nm, die Schichten 114 (Wolfram), 116 ($SiO_2$ und 118 (Wolfram) sind jeweils 500nm dick, die Schicht 120 ($SiO_2$) ist 1000nm dick. Der restliche Schichtstapel ist identisch zu den zuvor erwähnten Ausführungsbeispielen mit Ausnahme der Wolfram-Schicht oberhalb der Piezoschicht; hier wurde zur Frequenzkorrektur die Dicke auf 130nm reduziert (da diese Schicht oberhalb der Piezoschicht ist hat sie keinen Einfluss auf das Verhalten des akustischen Reflektors, wohl aber auf das Dispersionsverhalten). Man erkennt, dass erfindungsgemäß sowohl das Spiegelverhalten in Bezug auf longitudinale Wellen sowie Scherwellen sehr gut ist (Fig. 2D), als auch dass das Dispersionsverhalten nun eindeutig Typ I ist (Fig. 2E).

Nachfolgend sei ein weiteres Ausführungsbeispiel beschrieben. Im Unterschied zu den oben erwähnten Schichtstapeln besitzt dieser als oberste Schicht (auf der oberen Schicht der oberen Elektrode des Resonators) noch eine zusätzliche Passivierungsschicht aus Siliziumnitrid (kurz SiN). Aufgrund der Frequenzskalierbarkeit der hier vorgestellten Optimierung werden die Schichtdicken dieses Schichtstapels nicht mehr in absoluten Dicken angegeben, sondern in Dicke relativ zur longitudinalen Wellenlänge $\lambda_{long}$ in der jeweiligen Schicht, so dass sich die in der folgenden Tabelle wiedergegebenen Werte ergeben:

| Schicht Nr. | Material | Schichtdicke rel. zu $\cdot\lambda_{long}$ |
|---|---|---|
| 112 | SiO2 | 0,770 |
| 114 | Wolfram | 0,175 |
| 116 | SiO2 | 0,250 |

(fortgesetzt)

| Schicht Nr. | Material | Schichtdicke rel. zu $\cdot\lambda_{long}$ |
|---|---|---|
| 118 | Wolfram | 0,245 |
| 120 | SiO2 | 0,180 |
| 106a | Aluminium | 0,130 |
| 106b | Wolfram | 0,070 |
| 102 | AlN | 0,220 |
| 104a | Wolfram | 0,028 |
| 104b | Aluminium | 0,080 bis 0,12 |
| 104c | SiN | 0,008 |

Die Abweichungen von diesen Dicken müssen kleiner als 20% sein.

Hinsichtlich der oben beschriebenen, bevorzugten Ausführungsbeispiele wird darauf hingewiesen, dass die vorliegende Erfindung natürlich nicht hierauf beschränkt ist. Hinsichtlich der bevorzugten Ausführungsbeispiele wird darauf hingewiesen, dass die vorliegende Erfindung nicht auf BAW-Resonatoren beschränkt ist, welche Resonatorelemente umfassen, die als piezoelektrische Schicht Aluminiumnitrid (AlN) aufweisen. Statt dessen können als piezoelektrische Materialien, z.B. PZT oder Zn0 verwendet werden. Hinsichtlich der Elektrodenmaterialien, die oben beschrieben wurden, ist darauf hinzuweisen, dass die vorliegende Erfindung nicht auf die Kombination von Wolfram und Aluminium beschränkt ist, sondern statt dessen können auch einschichtige Elektroden oder andere Kombinationen von Materialien mit hoher akustischer Impedanz und Materialien mit niedriger akustischer Impedanz herangezogen werden.

Ferner wird darauf hingewiesen, dass sich zwischen den Schichten noch dünne Zwischenschichten befinden können, wie sie in der Halbleitertechnologie zu Haftvermittlung, als wachstumsfördernde Schichten ("seed layer") oder als Ätzstop üblich sind. Diese wurden hier nicht erwähnt, weil sie typischerweise so dünn sind, dass sie akustisch nicht berücksichtig werden müssen.

Anstelle der oben beschriebenen Siliziumsubstrate und der zusätzlich darauf aufgebrachten Strukturen sei darauf hingewiesen, dass die vorliegenden Erfindung nicht auf diese Siliziumsubstrate beschränkt ist, sondern dass auch andere, geeignete Substrate durch einen Fachmann herangezogen werden können.

Hinsichtlich der für die akustischen Reflektoren gemäß den bevorzugten Ausführungsbeispielen verwendeten Materialien sei darauf hingewiesen, dass die vorliegenden Erfindung nicht auf die Verwendung von $SiO_2$ als Material mit niedriger akustischer Impedanz beschränkt ist, sondern dass auch andere geeignete Materialien mit niedriger akustischer Impedanz verwendet werden können. Anstelle des als Material mit einer behen akustischen Impedanz verwendeten Wolframs können auch andere Materialien mit hoher akustischer Impedanz wie z.B. Molybdän, Platin, Titannitrid verwendet werden. Anstelle von akustischen Spiegeln mit zwei Schichten mit hoher akustischer Impedanz können auch mehr als zwei verwendet werden. Die erste Schicht oberhalb des Substrats muss keineswegs eine Schicht mit niedriger akustische Impedanz sein, so wie es für die Ausführungsbeispiele angenommen worden ist.

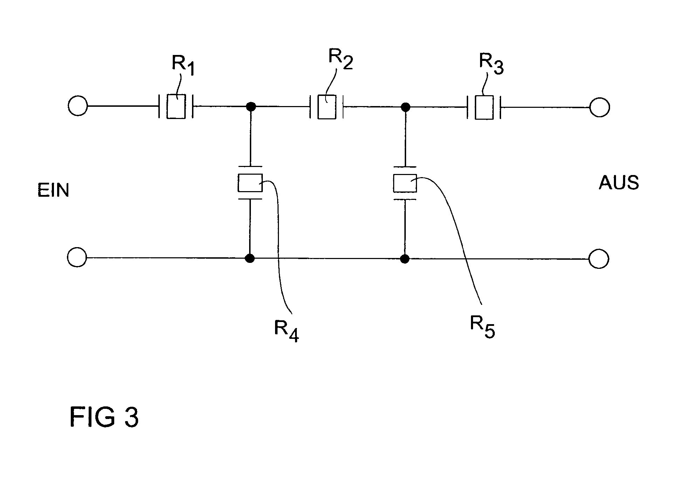

Gemäß einem weiteren Aspekt schafft die vorliegende Erfindung eine Filteranordnung, wie sie beispielsweise anhand der Fig. 3 beschrieben ist. Die Filteranordnung umfasst eine Mehrzahl von BAW-Resonatoren $R_1$, $R_2$ und $R_3$, welche in einem seriellen Zweig des Filters zwischen einem Eingangstor EIN und einem Ausgangstor AUS angeordnet sind. Die Resonatoren $R_1$ bis $R_3$ stellen die sogenannten Serienresonanzen des Filters bereit. Ferner sind bei dem dargestellten Beispiel der Filteranordnung die Resonatoren $R_4$ und $R_5$ vorgesehen, welche in den parallelen Zweigen des Filters angeordnet sind und die parallele Resonanz des Filters bereitstellen.

Es wird ferner darauf hingewiesen, dass die hier beschriebene Methode auch zur Optimierung des akustischen Reflektors von sog. "stacked crystal filtern" verwendet werden kann.

Erfindungsgemäß wird somit ein verbessertes Verhalten (Güten > 700) von BAW-Resonatoren erreicht, bei denen die Mehrzahl von Schichten des akustischen Reflektors und zwischen dem akustischen Reflektors und der piezoelektrischen Schicht angeordnete Schichten in Bezug auf deren Anzahl, Material und Dicke derart ausgewählt sind, dass die Transmissivität für die longitudinale Welle und für die Scherwelle im Bereich der Resonanzfrequenz kleiner als -10dB ist. Dies wird z.B. durch die oben beschriebenen Spiegel erreicht. Es ist für Fachleute in Anbetracht der obigen Lehren jedoch deutlich, dass dies auch durch andere Spiegelkonfigurationen erreichbar ist.

Bezugszeichenliste

| | |
|---|---|
| 100 | Resonatorelement |
| 102 | piezoelektrische Schicht |
| 104 | obere Elektrode |
| 106 | untere Elektrode |
| 106a | erste Schicht der unteren Elektrode |
| 106b | zweite Schicht der unteren Elektrode |
| 108 | Substrat |
| 110 | akustischer Reflektor |
| 112 | erste Schicht des akustischen Reflektors |
| 114 | zweite Schicht des akustischen Reflektors |
| 116 | dritte Schicht des akustischen Reflektors |
| 118 | vierte Schicht des akustischen Reflektors |
| 120 | fünfte Schicht des akustischen Reflektors |
| 200 | Resonator |
| 202 | Spiegel |
| 204 | longitudinale Anregung |
| 206 | Streuwelle |
| 208 | Streuwelle |
| 210 | longitudinale Welle |
| 212 | Scherwelle |
| 214 | erste Scher-Oberwelle |
| 216 | longitudinale Hauptresonanz |
| 218 | Scher-Hauptresonanz |
| R1-R5 | BAW-Resonatoren |
| EIN | Eingangstor der Filterschaltung |
| AUS | Ausgangstor der Filterschaltung |

**Patentansprüche**

1. BAW-Resonator (100), mit
   einer piezoelektrischen Schicht (102) mit einer ersten Oberfläche und einer zweiten, der ersten Oberfläche gegenüberliegenden Oberfläche;
   einer ersten Elektrode (104), die an der ersten Oberfläche der piezoelektrischen Schicht (102) angeordnet ist;
   einer zweiten Elektrode (106), die an der zweiten Oberfläche der piezoelektrischen Schicht (102) angeordnet ist;
   einem Substrat (108); und
   einem akustischen Reflektor (110), der zwischen dem Substrat (108) und der zweiten Elektrode (106) angeordnet ist, wobei der akustische Reflektor (110) eine Mehrzahl von Schichten aus einem Material mit hoher akustischer Impedanz und aus einem Material mit niedriger akustischer Impedanz aufweist, wobei alternierend Bereiche mit Schichten mit hoher akustischer Impedanz und Bereiche mit Schichten mit niedriger akustischer Impedanz benachbart angeordnet sind,
   wobei ein Verhalten des akustischen Reflektors (110) durch dessen Reflexionsvermögen für eine in dem BAW-Resonator (100) existierende longitudinale Welle (210) bei der Resonanzfrequenz des BAW-Resonators (100) und durch dessen Reflexionsvermögen für eine in dem BAW-Resonator (100) existierende Scherwelle (212) bei der Resonanzfrequenz des BAW-Resonators (100) bestimmt ist, und
   wobei die Schichten des akustischen Reflektors (110) und zwischen dem akustischen Reflektors (110) und der piezoelektrischen Schicht (102) angeordnete Schichten (106a, 106b) in Bezug auf deren Anzahl, Material und Dicke derart ausgewählt sind, dass die Transmissivität für die longitudinale Welle und die Transmissivität für die Scherwelle im Bereich der Resonanzfrequenz kleiner als -10dB ist.

2. BAW-Resonator (100) nach Anspruch 1, bei dem die Transmissivität die Transmissivität für die longitudinale Welle und für die Scherwelle im Bereich der Resonanzfrequenz kleiner als -15dB ist.

3. BAW-Resonator (100) nach Anspruch 1 oder 2, bei dem die Transmissivität für die longitudinale Welle im Bereich der Resonanzfrequenz kleiner als -20dB ist, und bei dem die Transmissivität für die Scherwelle im Bereich der Resonanzfrequenz kleiner als -15dB ist.

4. BAW-Resonator (100) nach einem der Ansprüche 1 bis 3, bei dem die Schichten des akustischen Resonators (100) derart gewählt sind, dass der BAW-Resonator ein eindeutiges und erwünschtes Dispersionsverhalten aufweist.

5. BAW-Resonator (100) nach Anspruch 4, bei dem die Schichten des akustischen Resonators (100) derart gewählt sind, dass der Abstand zwischen der longitudinalen Hauptresonanz (216) und der ersten Scher-Oberwelle (214) größer als die Bandbreite des Resonators ist.

6. BAW-Resonator (100) nach Anspruch 5, bei dem die Schichten des akustischen Resonators (100) derart gewählt sind, dass der Abstand zwischen der longitudinalen Hauptresonanz (216) und der ersten Scher-Oberwelle (214) größer als die Bandbreite der longitudinalen Hauptresonanz (216) des Resonators ist.

7. BAW-Resonator (100) nach einem der Ansprüche 1 bis 6, bei dem der akustischer Reflektor eine erste Schicht (112) mit niedriger akustischer Impedanz, eine zweite Schicht (114) mit hoher akustischer Impedanz, eine dritte Schicht (116) mit niedriger akustischer Impedanz, eine vierte Schicht (118) mit hoher akustischer Impedanz und eine fünfte Schicht (120) mit niedriger akustischer Impedanz umfasst.

8. BAW-Resonator (100) nach Anspruch 7, bei dem die Schichten (112, 116, 120) mit niedriger akustischer Impedanz $SiO_2$-Schichten sind, bei dem die Schichten (114, 118) mit hoher akustischer Impedanz W-Schichten sind.

9. BAW-Resonator (100) nach Anspruch 7 oder 8, der die in der folgenden Tabelle wiedergegebene Schichtfolge aufweist

| Schicht Nr. | Material | Schichtdicke rel. zu $\cdot\lambda_{long}$ |
|---|---|---|
| 112 | SiO2 | 0,770 |
| 114 | Wolfram | 0,175 |
| 116 | SiO2 | 0,250 |
| 118 | Wolfram | 0,245 |
| 120 | SiO2 | 0,180 |
| 106a | Aluminium | 0,130 |
| 106b | Wolfram | 0,070 |
| 102 | AlN | 0,220 |
| 104a | Wolfram | 0,028 |
| 104b | Aluminium | 0,080 bis 0,12 |
| 104c | SiN | 0,008 |

wobei die Schichtdicken relativ zu der longitudinalen Wellenlänge $\cdot\lambda_{long}$ in der jeweiligen Schicht angegeben ist, und
wobei Abweichungen von diesen Dicken kleiner als 20% sein müssen.

10. Filterschaltung mit einer Mehrzahl von BAW-Resonatoren ($R_1$ bis $R_5$) nach einem der Ansprüche 1 bis 8.

11. Filterschaltung nach Anspruch 9, bei der die Resonatorelemente und die akustischen Reflektoren der Mehrzahl von BAW-Resonatoren ($R_1$ bis $R_5$) auf einem gemeinsamen Substrat gebildet sind.

EP 1 418 671 A2

104

100

102

106b

106a

106

120

118

116

114

112

110

108

FIG 1A

EP 1 418 671 A2

FIG 1B

FIG 1C

EP 1 418 671 A2

FIG 2A

EP 1 418 671 A2

FIG 2B

EP 1 418 671 A2

FIG 2C

EP 1 418 671 A2

FIG 2D

EP 1 418 671 A2

FIG 2E

$R_1$  $R_2$  $R_3$

EIN  AUS

$R_4$  $R_5$

FIG 3